(19) **Europäisches Patentamt / European Patent Office / Office européen des brevets**

(11) **EP 2 606 160 B1**

(12) # EUROPEAN PATENT SPECIFICATION

(45) Date of publication and mention
of the grant of the patent:
**10.06.2015 Bulletin 2015/24**

(21) Application number: **11748832.0**

(22) Date of filing: **10.08.2011**

(51) Int Cl.:
*C22C 12/00* (2006.01)     *H01L 35/18* (2006.01)

(86) International application number:
**PCT/US2011/047172**

(87) International publication number:
**WO 2012/024120 (23.02.2012 Gazette 2012/08)**

(54) **P-TYPE SKUTTERUDITE MATERIAL AND METHOD OF MAKING THE SAME**

P-ARTIGER SKUTTERUDITSTOFF UND HERSTELLUNGSVERFAHREN DAFÜR

MATÉRIAU EN SKUTTÉRUDITE DE TYPE P ET SON PROCÉDÉ DE FABRICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **20.08.2010  CN 201010259433**

(43) Date of publication of application:
**26.06.2013  Bulletin 2013/26**

(73) Proprietor: **Shanghai Institute of Ceramics,
Chinese Academy of Sciences
Shanghai, 200050 (CN)**

(72) Inventors:
- **BACKHAUS-RICOULT, Monika**
  **Horseheads**
  **New York 14845 (US)**
- **CHEN, Lidong**
  **Shanghai 200336 (CN)**
- **HE, Lin**
  **Horseheads**
  **NY 14845 (US)**
- **HUANG, Xiangyang**
  **Shanghai 200439 (CN)**
- **LIU, Ruiheng**
  **Shanghai 200050 (CN)**
- **QIU, Pengfuei**
  **Shanghai 201800 (CN)**
- **YANG, Jiong**
  **Shanghai 200333 (CN)**
- **ZHANG, Wenqing**
  **Shanghai 200336 (CN)**

(74) Representative: **Oldroyd, Richard Duncan
Elkington and Fife LLP
Prospect House
8 Pembroke Road
Sevenoaks, Kent TN13 1XR (GB)**

(56) References cited:
- **ICHIMIN SHIROTANI ET AL: "X-ray study with synchrotron radiation for P- and Sb-based skutterudite compounds at high pressures", JOURNAL OF PHYSICS: CONDENSED MATTER, vol. 16, no. 43, 3 November 2004 (2004-11-03), pages 7853-7862, XP55012062, ISSN: 0953-8984, DOI: 10.1088/0953-8984/16/43/024**
- **ZHANG, LONG: "Nanostructured Bulk Thermoelectric Materials (Skutterudites)", , 9 January 2010 (2010-01-09), XP002663522, Retrieved from the Internet: URL:http://othes.univie.ac.at/8256/1/2009-12-09_0648464.pdf [retrieved on 2011-11-14] & ZHANG, LONG: "Nanostructured Bulk Thermoelectric Materials (Skutterudites)", , 9 January 2010 (2010-01-09), Retrieved from the Internet: URL:http://othes.univie.ac.at/8256/ [retrieved on 2011-11-14]**
- **PING WEI, WEN-YU ZHAO, CHUN-LEI DONG, BING MA, QING-JIE ZHANG: "Thermal stability of barium and indium double-filled skutterudite Ba0.3In0.2Co3.95Ni0.05Sb12 coated by SiO2 nanoparticles", JOURNAL OF ELECTRONIC MATERIALS, vol. 39, no. 9, 9 March 2010 (2010-03-09), pages 1803-1808, DOI: 10.1007/s11664-010-1116-5**

**(Cont. next page)**

EP 2 606 160 B1

- XIONG Z ET AL: "High thermoelectric performance of Yb0.26Co4Sb12/yGaSb nanocomposites originating from scattering electrons of low energy", ACTA MATERIALIA, ELSEVIER, OXFORD, GB, vol. 58, no. 11, 1 June 2010 (2010-06-01), pages 3995-4002, XP027045201, ISSN: 1359-6454 [retrieved on 2010-04-13]

- XIONG Z ET AL: "High thermoelectric performance of Yb0.26Co4Sb12/yGaSb nanocomposites originating from scattering electrons of low energy", ACTA MATERIALIA, ELSEVIER, OXFORD, GB, vol. 58, no. 11, 1 June 2010 (2010-06-01), pages 3995-4002, XP027045201, ISSN: 1359-6454 [retrieved on 2010-04-13]

**Description**

**TECHNICAL FIELD**

The disclosure relates to the field of p-type skutterudite material, providing a high thermoelectric performance p-type skutterudite material and a method of making the same.

**BACKGROUND OF THE ART**

Thermoelectric conversion technology can directly convert thermal energy into electric energy by using the Seebeck effect of a material, or provide refrigeration using the Peltier effect. These technologies have the advantages of no moving components, high reliability, long lifetime and environmentally-friendly systems, etc., which can be widely used for generating electricity in waste energy recovery, as power supply for navigation and spaceflight, for medical refrigeration, and for household refrigeration appliances, for example. The efficiency of thermoelectric conversion is mainly determined by the dimensionless figure of merit, defined as $ZT = S^2 \sigma\, T / \kappa$, where S, $\sigma$, $\kappa$ and $T$ are respectively the Seebeck coefficient, electrical conductivity, thermal conductivity and absolute temperature. The higher the ZT value is, the higher the conversion efficiency of thermal energy to electricity.

In the typical application of thermoelectric technology, p-type and n-type thermoelectric materials are built up to form a thermoelectric device pair, and the efficiency of conversion of heat energy to electrical energy and temperature difference of the pair are closely related to average Z values of the respective materials across the temperature range of use. Theoretically, the maximum efficiency of the conversion of heat energy to electrical energy is given by:

$$\eta_{\max} = \frac{T_h - T_l}{T_h} \frac{\left(1 + Z\overline{T}\right)^{1/2} - 1}{\left(1 + Z\overline{T}\right)^{1/2} + T_l \big/ T_h}$$

where $\overline{T} = (T_h + T_l)/2$ is the average temperature, and $Z\overline{T} = S^2 \sigma \overline{T}/\kappa$ is the average ZT value of p-type and n-type semiconductors in the whole temperature range $T_l \sim T_h$. The conversion efficiency of the device can be enhanced only when both the ZT values of p-type and n-type are improved simultaneously.

Filled-skutterudites are a group of thermoelectric conversion materials mainly applied in the high temperature range of 500~800 K for their good electrical transport properties and depressed thermal conductivity. Small radius atoms incorporated into the peculiar icosahedral cages of such skutterudites create a rattling effect. With the perturbation generated by the weak bonding between filled atoms and adjacent atoms, the phonons with low frequency are strongly scattered by the rattling effect. As a result, the lattice thermal conductivity of filled-skutterudites is depressed in a large scale, which makes the ZT of n-type skutterudites typically greater than 1. But in p-type skutterudites, the filling fractions of atoms are greatly dependent on the doping content, which increases the difficulty of materials preparation. Generally, the ZT values of p-type skutterudites are lower than that of n-type.

When filled into the voids of p-type skutterudites, due to mass divergence, radii divergence and valence divergence, various atoms can strongly interact with phonon with different frequency modes, while filling atoms generally scatter phonons with corresponding frequencies. To scatter as wide a spectrum of normal phonons as possible and obtain the lowest thermal conductivity, filling the skutterudites structure with atoms that have different localized frequencies (multi-filling) might be a further effective way.

In the multi-filling area, $(Ce/Yb)_y Fe_{4-x}(Co/Ni)_x Sb_{12}$ alloys have been prepared through arc-melting combined with solid reaction. However, the process with long period and high complication was not suitable for control the composition of the materials. $DD_y Fe_{4-x}(Co/Ni)_x Sb_{12}$ and $Mm_y Fe_{4-x}Co_x Sb_{12}$ have been prepared through repeated solid state reactions. Since the raw material used were raw rare-earth Didymium (4.76 mass% Pr and 95.24% Nd) and Misch-metal (21 at% La, 53% Ce, 6% Pr and 19% Nd), the filling fraction of particular atoms can not be adjusted freely, which diminishes the advantages of using the combination of the resonance frequencies from the different filling atoms.

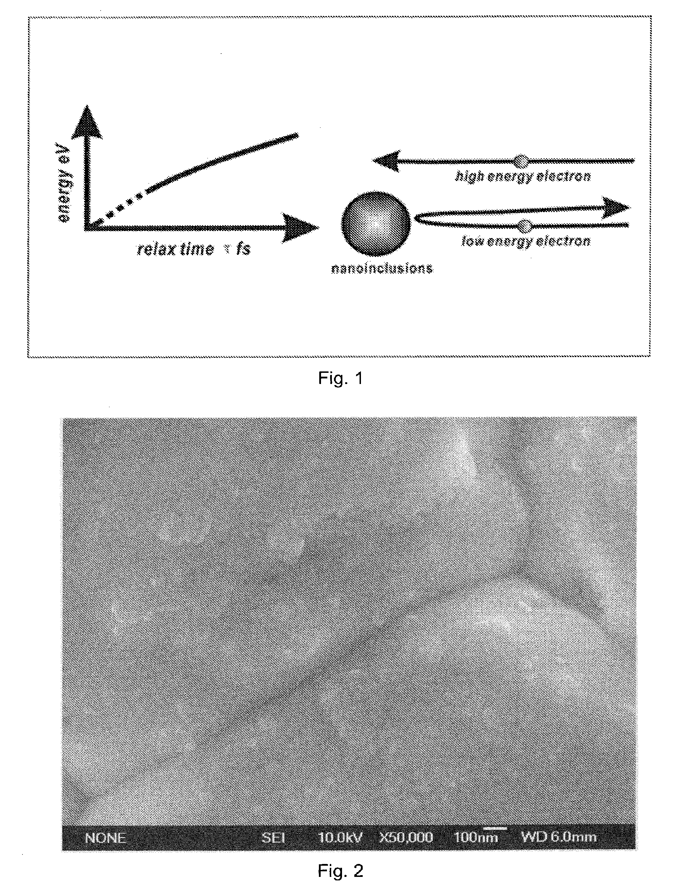

Besides multi-filling, nanoscale or submicron inclusions worked as phonon scattering centers can be introduced into the thermoelectric matrix to scatter phonons, and minimize the thermal conductivity. Generally, the second phase is second phase particle. The phonons, which are worked as heat carriers, have a wide range frequency distribution and nanoscale inclusions with different sizes can scatter phonons possessing equivalent wavelength. The inclusions with sizes in the range of 50~300 nm are believed to have little influence on the electrical transport property. However, as the size of nano inclusions decreases to 10~20 nm, the scattering effects of nano inclusions to electrical carriers become important, and low energy electrons can be filtered. The electrons with low energy have a smaller contribution to the Seebeck coefficient. As a result, the Seebeck coefficient will be enhanced on a large scale. Furthermore, the total thermal conductivity remains almost unchanged or a lower level, so the ZT value will increase in a wide temperature range. Figure 1 show schematic view of nano-inclusions filtering low energy electrons.

The dispersion of the nanoscale inclusions in the filled-skutterudite matrix is critical for the scattering effects to phonons and electrons. Generally, several methods are usually applied to introduce nanoscale inclusions.

One approach is mechanical mixing. Researchers have fabricated $CoSb_3/FeSb_2$ and $CoSb_3/NiSb$ composites via mechanical ball-milling. The thermoelectric properties of the resulting composites are improved as compared with conventional $CoSb_3$. The process is simple and convenient. However, the aggregation of nano-powder is hardly to be broken. So the nano-particle can not be dispersed homogeneously in the matrix, and the scattering effects are to be restricted.

A further approach is oxidizing one component of the matrix. Researchers have oxidized $CoSb_3$ powder and obtained a thin oxide film on the powder's surface. As a result, the thermal conductivity was depressed and the Seebeck coefficient was increased. However, it is hard to control the oxidation condition of the matrix accurately via adjusting temperature, oxygen partial pressure, and other technique parameters. On the basis of keeping the thermoelectric high performance of the matrix, a proper technique process is not easy to be optimized.

A still further approach involves incorporating metal nanoscale precipitate inclusions in the matrix. These can originate from one component of the matrix (in-situ separating out method). For example, Sb nanoscale inclusions can be precipitated in the filled-skutterudite. Such in-situ method can provide homogeneous dispersion of the nanoscale inclusions in the matrix. However, Sb is a metal phase with low melting point (~631°C) and high vapor pressure (0.01kPa at 597°C), so it is easy to volatilize in the working condition at high temperatures. Furthermore, excess Sb will bring high electrical carrier to the matrix and deteriorate the electrical transport properties of the composites. In a word, the in-situ method can precipitate metal nanoscale inclusions in the matrix homogeneously, whereas it is difficult to form stable nanoscale inclusions with proper component and technique.

A further approach involves hydrothermal coating. Researchers have coated a layer of nano $CoSb_3$ particles outside of $La_{0.9}CoFe_3Sb_{12}$ particles with the hydrothermal method, then resintered to obtain a composite material. However, such method cannot homogeneously disperse $CoSb_3$ particles throughout the material, but enriches the particles on the boundary of the material, thus significantly destroying the electric transmission property of the material.

A superlattice thermodynamically metalstable skutterudite was reported to enhance the thermoelectric performance of the thermoelectric materials. The typical superlattice structure is made by atomic level, layer-by-layer 2D structure. If the superlattice structure is extended into 3D, it should be a 3D network. The superlattice structure is normally easy to form for those with anisotopic crystal structure. However, skutterudites have an isotopic crystal structure which may not be easy to form the superlattice structure in the skutterudite matrix with consistent properties.

In view of the foregoing, in the field of p-type skutterudite materials, not only an effective multi-filled material, but also a stable composite material do not exist, and the material obtained by combining both and its preparation process also do not exist.

Therefore, it is critical to develop a p-type skutterudite material, which, as compared with the conventional p-type skutterudite material, has significantly increased power factor, significantly reduced total thermal conductivity, increased ZT value in a range of service temperatures, and increased theoretical thermoelectric conversion efficiency.

## SUMMARY

The present disclosure provides a novel high thermoelectric performance p-type skutterudite material and a method of making the same. As compared with the conventional p-type skutterudite material, the material has significantly increased power factor, significantly reduced total thermal conductivity, increased ZT value (over 10%) in a range of service temperature, and increased theoretical thermoelectric conversion efficiency (over 9%). The process thereof is controllable and has good industrialization prospect. Thus the problems of the prior art have been solved.

In one aspect, the present disclosure provides a p-type skutterudite material having a general formula $I_yFe_{4-x}M_xSb_{12}/z(J)$ wherein I represents one or more filling atoms in a skutterudite phase, with the total filling amount y satisfying $0.01 \leq y \leq 1$; M represents one or more dopant atoms, with the doping amount x satisfying $0 \leq x < 3$; J represents one or more second phases, with the molar ratio z satisfying $0 < z \leq 0.5$, such that second phase precipitates are dispersed throughout the skutterudite phase.

In one embodiment, $0.05 \leq y \leq 1$. In another embodiment, $0.1 \leq y \leq 1$. In another embodiment, the p-type skutterudite material further comprises one or more dopant atoms in the skutterudite phase. In another embodiment, the skutterudite material is single-filled and comprises one or more second phase precipitates dispersed throughout the skutterudite phase. In another embodiment, the skutterudite material is multi-filled and comprises one or more second phase precipitates dispersed throughout the skutterudite phase.

In embodiments, the second phase is a semiconducting material having a band gap in a range of 0.3 to 1eV. The second phase can comprise nanoscale particles having a size in a range of 2 to 500nm. In an embodiment, the second phase has a melting point greater than 400°C. In a further embodiment, the second phase is homogeneously dispersed throughout the skutterudite phase. In a still further embodiment, the second phase is dispersed along grain boundaries of the skutterudite phase. The second phase can be dispersed throughout crystal grains of the skutterudite phase.

I is selected from the group consisting of Na, K, Ca, Sr, Ba, La, Ce, Pr, Nd, Sm, Eu, Gd and Yb; M is selected from the group consisting of Co, Ni, Ru, Rh, Os, Ir and Pt; and J is selected from the group consisting of GaAs, GaSb, InAs, InSb, $Zn_3Sb_4$ and solid solutions thereof.

The present disclosure relates also to a method of making the p-type skutterudite material, comprising melting precursor materials within a vessel to form an intermediate compound; quenching the intermediate compound to form an ingot; annealing the ingot; grinding the ingot into a powder; and sintering the powder to form the p-type skutterudite material.

In an embodiment, the vessel comprises a protective coating. In another embodiment, the vessel is vacuumed, and during melting a pressure within the vessel is in a range of from 0.1 to 40000Pa. In another embodiment, a melting temperature is from 900 to 1200°C. In another embodiment, a quenching rate is from 50 to $1 \times 10^6$ K/sec. In another embodiment, an annealing temperature is from 400 to 850°C. In another embodiment, a sintering temperature is from 500 to 650°C.

## BRIEF DESCRIPTION OF THE DRAWINGS

Fig. 1 is a schematic view of nanoinclusions filtering low energy electrons.

Fig. 2 is FESEM (field emission scanning electron microscope) image for $CeFe_4Sb_{12}$/0.2 GaSb bulk section in Example 1, showing that GaSb particles having a size of 10-100 nm are dispersed in the matrix.

Fig. 3 shows Power factor vs. temperature for the $CeFe_4Sb_{12}$/0.2 GaSb composite material in Example 1, indicating that the power factor ($S^2\sigma$) increases in the high temperature range due to the great increase of Seebeck coefficient.

Fig. 4 shows total thermal conductivity vs. temperature for the $CeFe_4Sb_{12}$/0.2 GaSb composite material in Example 1, indicating that the total thermal conductivity decreases due to the depressed lattice thermal conductivity, wherein total thermal conductivity is expressed by $\kappa$.

Fig. 5 shows merit (ZT) vs. temperature for the $CeFe_4Sb_{12}$/0.2 GaSb composite material in Example 1, indicating that the ZT value increases by 10% in the high temperature range due to the introduction of nanoparticle GaSb.

Fig. 6 shows Power factor vs. temperature for the $Ce_{0.45}Nd_{0.45}Fe_3CoSb_{12}$ in Example 2, indicating that the power factor ($S^2\sigma$) increase in the whole temperature due to the great increase of electrical conductivity.

Fig. 7 shows total thermal conductivity vs. temperature for the $Ce_{0.45}Nd_{0.45}Fe_3CoSb_{12}$ in Example 2, indicating that the total thermal conductivity decreases as compared with single-filled matrix due to the depressed lattice thermal conductivity.

Fig. 8 shows merit (ZT) vs. temperature for the $Ce_{0.45}Nd_{0.45}Fe_3COSb_{12}$ in Example 2, indicating that the ZT value increases by 10% at 700K, and the ZT also increases in the whole temperature range.

Fig. 9 is a processing flow chart of making filled p-type skutterudite thermoelectric composite material according to one embodiment of the present disclosure.

Fig. 10 is a processing flow chart of making multi-filled skutterudite thermoelectric material according to one embodiment of the present disclosure.

Fig. 11 is the processing flow chart of making multi-filled p-type skutterudite thermoelectric composite material according to one embodiment of the present disclosure.

## DETAILED DESCRIPTION

After extensive and intensive study, the present inventors have obtained a novel high thermoelectric performance p-type skutterudite composite material. As compared with the conventional p-type skutterudite material, the material has significantly increased power factor, significantly reduced total thermal conductivity, increased ZT value (over 10%) in a range of using temperature, increased theoretical thermoelectric conversion efficiency (over 9%), and improved mechanical property. The process thereof is controllable and has good industrialization prospect

In one embodiment, a high thermoelectric performance p-type skutterudite composite material is disclosed, which may be composed of the following three groups of materials. (A) The material can use a single-filled doped skutterudite as a matrix, and nanoparticles as composite second phase. (B) The material can be a multi-filled doped skutterudite material. Or, (C) the material can be the combination of the above materials, i.e., a multi-filled doped skutterudite material as a matrix, and nanoparticles as a composite second phase.

The three groups of materials may be represented by a general formula $I_yFe_{4-x}M_xSb_{12}$/z(second phase), wherein I represents filling atoms, which is at least one of Na, K, Ca, Sr, Ba, La, Ce, Pr, Nd, Sm, Eu, Gd and Yb; M represents dopant atoms, which is at least one of Co, Ni, Ru, Rh, Os, Ir, Pd and Pt; y is the filling amount of the filling atoms, satisfying $0.01 \leq y \leq 1$; x is the doping amount of the doping atoms, satisfying $0 \leq x < 3$; z is the molar ratio of second phase particles, satisfying $0 < z \leq 0.5$; and the second phase particles may be one of GaAs, GaSb, InAs, InSb and $Zn_3Sb_4$, or solid solutions of two or more of GaAs, GaSb, InAs, InSb, $Zn_3Sb_4$.

In the present disclosure, the second phase is a semiconducting material having a band gap in a range of 0.3 to 1eV, so as not to increase the concentration of current carrier of the matrix like metal phase. The second phase can comprise nanoscale particles having a size in a range of 2 to 500nm.

In a further embodiment, a method of making the above three groups of p-type skutterudite materials comprises weighing stoichiometric amounts of the raw materials ($I_yFe_{4-x}M_xSb_{12}$ as a matrix, z(second phase) as a composite second phase) and combining, then sealing the materials into a quartz tube, wherein I represents one or more atoms selected from the group consisting of Na, K, Ca, Sr, Ba, La, Ce, Pr, Nd, Sm, Eu, Gd and Yb, with the total filling amount thereof satisfying $0.01 \leq y \leq 1$ (preferably $0.05 \leq y \leq 1$, more preferably $0.1 \leq y \leq 1$); M is at least one selected from the group consisting of Co, Ni, Ru, Rh, Os and Ir, with the dopant amount thereof satisfying $0 \leq x < 3$; the second phase is GaAs, GaSb, InAs, InSb, $Zn_3Sb_4$, or solid solutions thereof, its molar ratio satisfying $0 < z \leq 0.5$. The method further comprises heating the sealed quartz tube, melting and quenching; annealing the quenched quartz tube; and grinding the solid bulk of annealed $I_yFe_{4-x}M_xSb_{12}$/z(second phase) into a powder, and press sintering the obtained powder to form a high thermoelectric performance p-type skutterudite composite material.

In the present disclosure, raw materials of elements or compounds with high purity are weighted stoichiometrically in a glove box full of inert gas Ar, then the raw materials are sealed into a quartz tube by Ar plasma.

To avoid the reaction of raw materials and the quartz tube, the inner wall of quartz tube may have a protective layer, i.e., the walls of the quartz tube can be deposited by a thin carbon film, alternatively, a graphite crucible or tantalum crucible can be inserted to load raw materials.

In embodiments, the quartz tube is vacuumed during sealing, and the pressure of tube is 0.1~40000 Pa. The temperature of the quartz tube loaded with raw materials can be increased at a rate of 0.5~3°C/min, until the temperature reaches 900~1200°C, then held for 1-48 h before quenching.

The quench methods can include quenching with a quenching medium, or quenching via MS (melt spinning) with cooling rates as high as 50°C/sec to $1 \times 10^6$ °C/sec, wherein the quenching medium can be air, water, saturated salted water, oil, or liquid nitrogen. In embodiments, the quenched quartz tube is annealed at 400~850°C for 5~300 hours.

In further embodiments, the annealed solid bulk can be ground into fine powders, then the obtained powder consolidated via a pressed sintering technique, i.e., spark plasma sintering, or hot-pressed sintering, wherein the sintering temperature can be 500~650°C; the sintering time 5~120 min, with a pressure at 10~100 MPa.

The second phase particles can be dispersed throughout the grain boundaries of the skutterudite grains, within the grain of matrix material, or the combination thereof.

In embodiments, the second phase has a relative high melting point >700K (>423C), and can be stable in service and are dispersed well in the matrix of p-type skutterudites.

The second phase can be produced by in-situ method and/or ex-situ techniques.

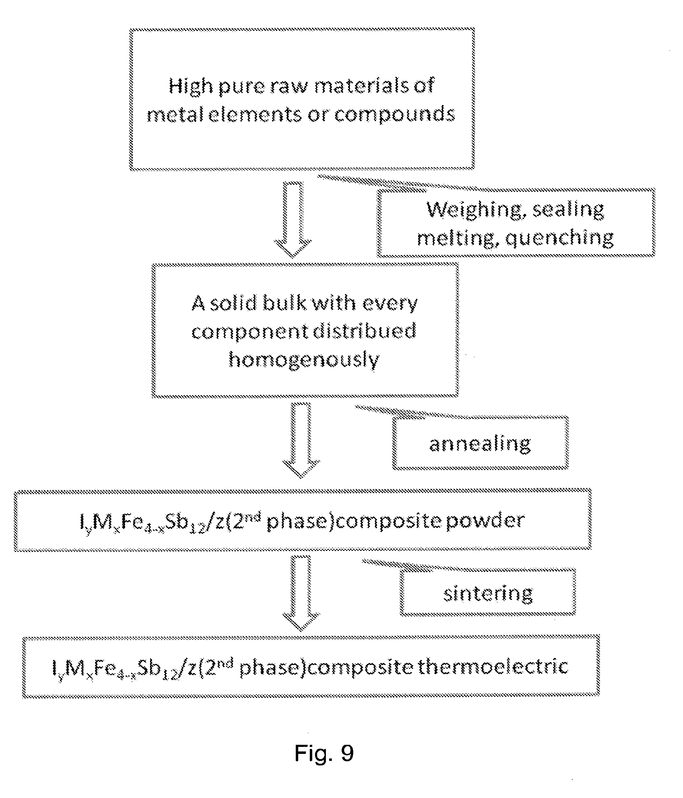

Fig. 9 is a processing flow chart of making filled p-type skutterudite thermoelectric composite material of Group (A). As illustrated in Fig. 9, the method includes using high purity raw materials of metal elements or compounds, weighing stoichiometrically the raw materials in a glove box full of inert Ar, then the raw materials are sealed into a quartz tube by plasma such Ar; heating the sealed quartz tube, melting and quenching to form a crystal bar on which each component is homogeneously dispersed; annealing the obtained crystal bar to form a p-type skutterudite composite powder of $I_yFe_{4-x}M_xSb_{12}$/z(second phase); and pressed sintering the obtained powder to form high thermoelectric performance nano skutterudite composite material of $I_yFe_{4-x}M_xSb_{12}$/z(second phase).

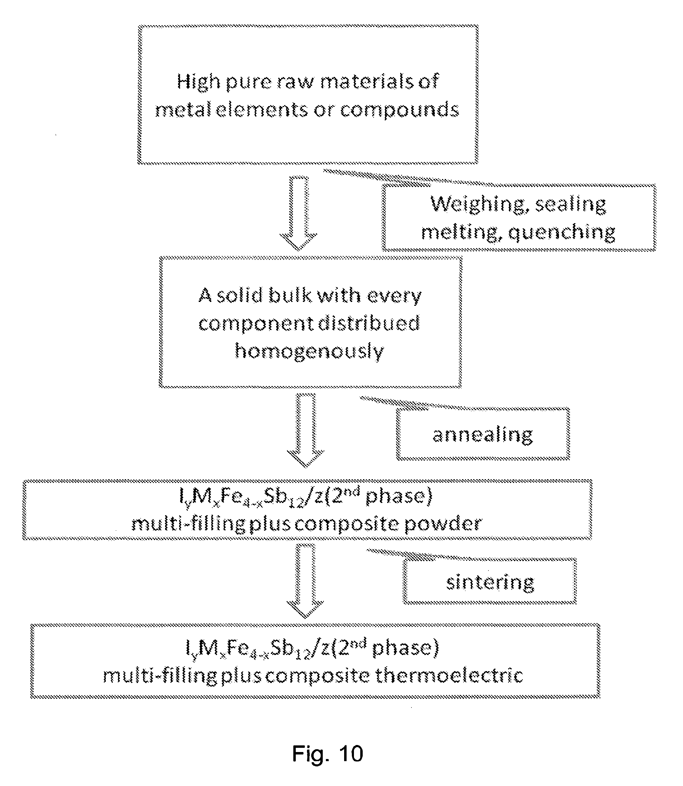

Fig. 10 is a processing flow chart of making multi-filled skutterudite thermoelectric material of Group (B). As illustrated in Fig. 10, the processing flow includes using high purity raw materials of metal elements or compounds, weighing stoichiometrically the raw materials in a glove box full of inert Ar, then the raw materials are sealed into a quartz tube by plasma such Ar; heating the sealed quartz tube, melting and quenching to form crystal bar on which each component is homogeneously dispersed; annealing the obtained crystal bar to form a p-type skutterudite composite powder of $I_yFe_{4-x}M_xSb_{12}$; and pressed sintering the obtained powder to form high thermoelectric performance p-type multi-filled skutterudite composite material of $I_yFe_{4-x}M_xSb_{12}$.

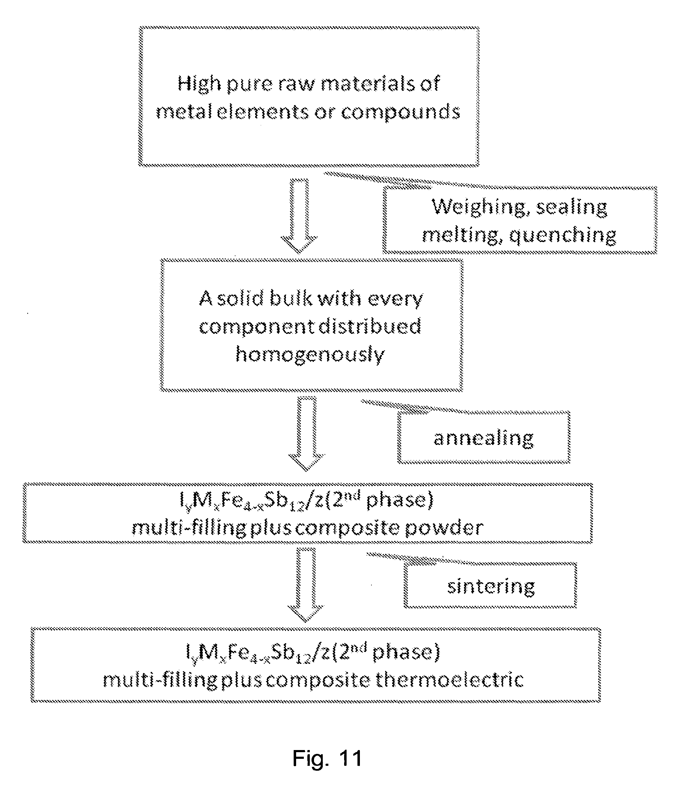

Fig. 11 is a processing flow chart of making multi-filled p-type skutterudite thermoelectric composite material of Group (C). As illustrated in Fig. 11, the processing flow includes using high purity raw materials of metal elements or compounds, weighing stoichiometrically the raw materials in a glove box full of inert Ar, then the raw materials are sealed into a quartz tube by plasma such Ar; heating the sealed quartz tube, melting and quenching to form crystal bar on which each component is homogeneously dispersed; annealing the obtained crystal bar to form a multi-filled skutterudite composite powder of $I_yFe_{4-x}M_xSb_{12}$/z(second phase); and pressed sintering the obtained powder to form high thermoelectric performance multi-filled p-type skutterudite composite material of $I_yFe_{4-x}M_xSb_{12}$/z(second phase).

Advantages associated with the present disclosure include realization of the maximum theoretical conversion efficiency of the thermoelectric device built up by such p-type. The efficiency is enhanced at least from 9.3% to 12.1%. The figure-of-merit (ZT) values of the three group materials are increased 10-30%. Also, the inclusions of the second phase are precipitated by an in situ method and well dispersed in the filled-skutterudite matrix, which is very important for scattering low energy electrons. The second phase is easily formed through reaction. The disclosure provides the advantages of making three groups of p-type skutterudite with controllable processes, which are promising for mass production and manufacturing application; and the thermoelectric materials made through the disclosed methods have the characteristics of higher Seebeck coefficient, higher power factor and lower total thermal conductivity, wherein multi-filled skutterudite decreases thermal conductivity of the material; the composite second phase (a) increases Seebeck coefficient, and (b) lowers total thermal conductivity; and multi-filled plus composite second phase improves electrical transport properties, lower thermal conductivity, and maintain the higher Seebeck coefficient.

### Examples

The disclosure is to be illustrated in more details with reference to the following specific examples. However, it is to be appreciated that these examples are merely intended to be exemplary without limiting the scope of the invention in any way. In the following examples, if no conditions are denoted for any given testing process, either conventional conditions or conditions advised by manufacturers should be followed. All percentages and parts are based on weight unless otherwise indicated.

### Example 1: $CeFe_4Sb_{12}/0.2GaSb$ composite material

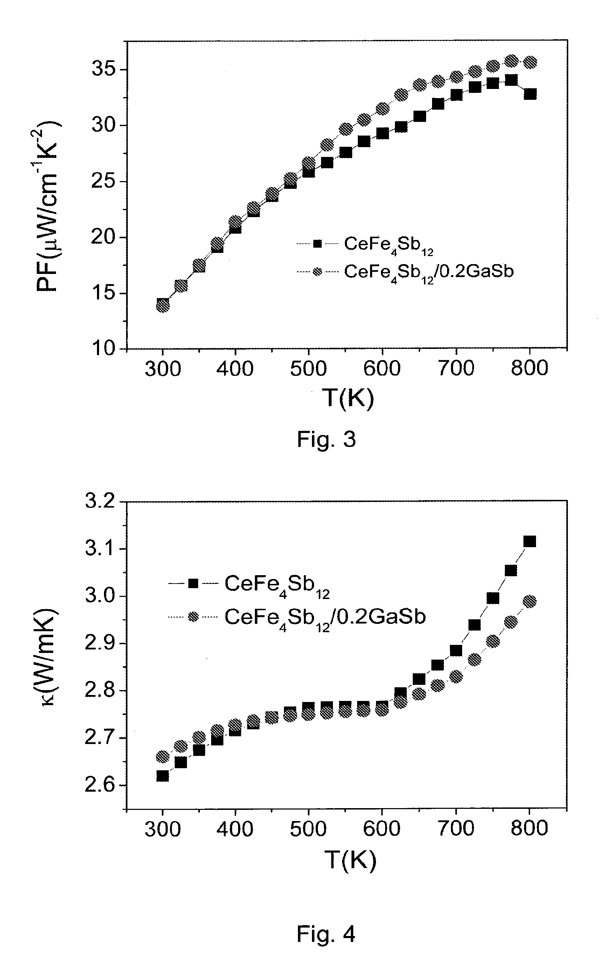

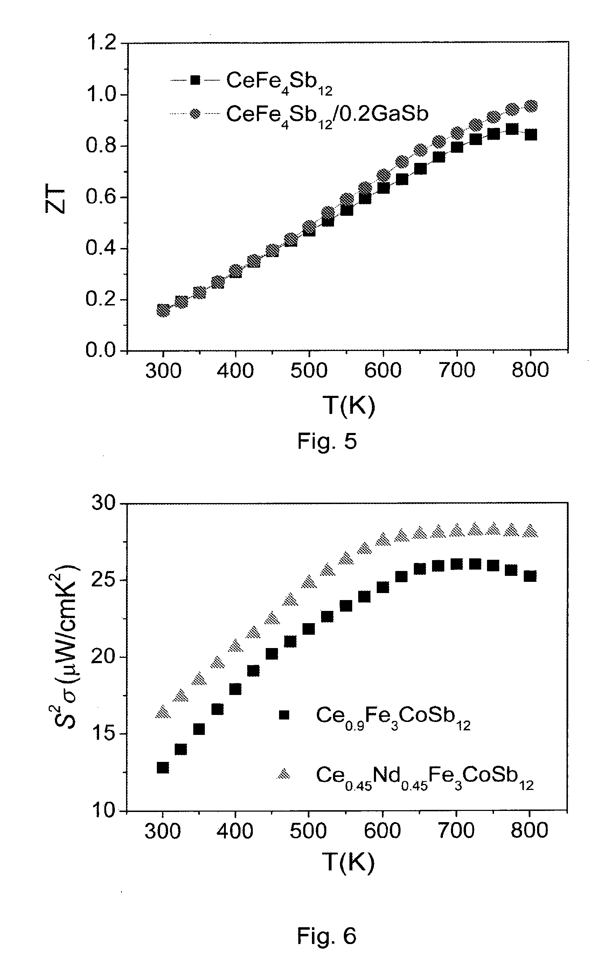

Highly pure metal raw materials Ce, Fe, Sb and Ga were weighted in molar ratio 1: 4: 12.2: 0.2 in a glove box. The raw materials were put into quartz tubes, in which the whole wall was coated with carbon film. The quartz tubes were vacuumed and sealed by Ar plasma. The raw materials were melted at 1000°C, and the duration time was 12 hrs. Subsequently, the quartz tubes were quenched in saturated salt water at a quenching rate of about 300°C/sec. And then the condensated bulks (still in quartz tubes under vacuum) were annealed at 700 °C for 120 hrs. The obtained fine powders of $CeFe_4Sb_{12}$ and $CeFe_4Sb_{12}/0.2$ GaSb composite grounded from bulks were consolidated by spark plasma sintering (SPS) at 600°C for 5 min under a pressure of 50MPa. The results of phase analysis, structure, and thermoelectric properties are shown in Figures 2 to 5. The FESEM image shows that the second phase (GaSb phase) is well dispersed on or within the boundary of the grains of matrix material (Figure 2). Thermoelectric property tests indicate that $CeFe_4Sb_{12}/0.2$ GaSb has increased power factor as compared with the filled skutterudite matrix (See Figure 3) and lower total thermal conductivity (See Figure 4). ZT value result indicates that p-type skutterudite composite material has better thermoelectric property than the matrix which is not compounded, ZT value reaching 0.95 at 800K (See Figure 5).

### Example 2: $Ce_{0.45}Nd_{0.45}Fe_3CoSb_{12}$ material (comparative)

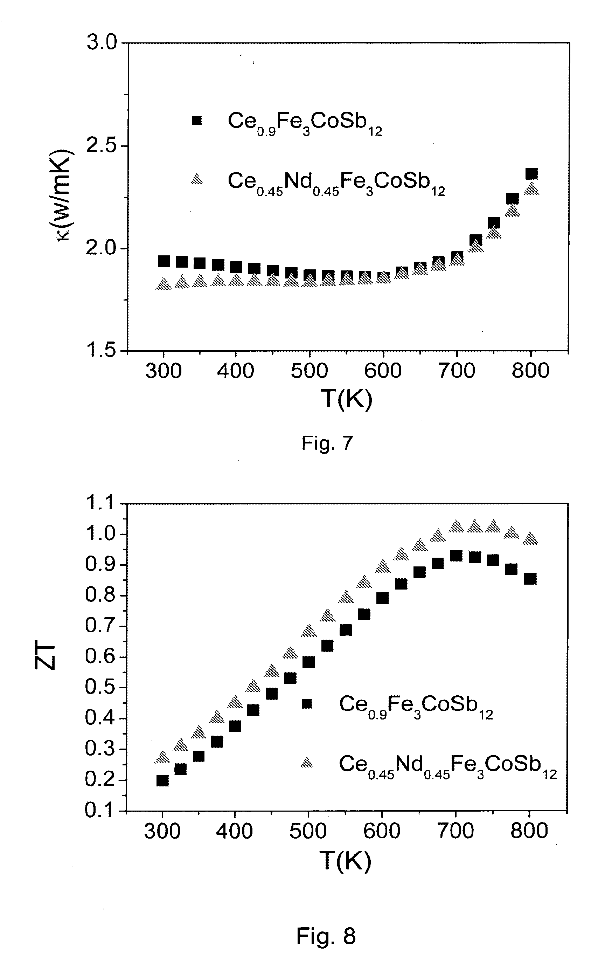

Highly pure metals raw materials Ce, Nd, Fe, Co and Sb were weighted in molar ratio 0.45: 0.45: 3: 1: 12 in the glove box, respectively. The raw materials were put into a quartz tube, in which the whole wall was coated with carbon film. The quartz tubes were vacuumed and sealed by Ar plasma. The raw materials sealed in quartz tubes were heated with ramp rate 3°C/min and melted at 1000°C, and the duration time was 12 hrs. Subsequently, the quartz tubes were quenched in saturated salt water at a quenching rate of about 300°C/sec. And then the condensated bulks (still in quartz tubes under vacuum) were annealed at 600 °C for 200 hrs. The obtained fine powders grounded from bulks were consolidated by spark plasma sintering (SPS) at 600°C for 10 min under a pressure of 60 MPa. The thermoelectric properties are shown in Figures 6 to 8. Tests indicate that $Ce_{0.45}Nd_{0.45}Fe_3CoSb_{12}$ has increased power factor as compared with the (single) filled skutterudite $Ce_{0.9}Fe_3CoSb_{12}$ (See Figure 6) and lower total thermal conductivity (See Figure 7). ZT value results indicate that multi-filled skutterudite material has better thermoelectric property than the conventional $Ce_{0.9}Fe_3CoSb_{12}$, ZT value reaching 1.02 at 750K (See Figure 8).

### Example 3: $Ce_yFe_xCo_{4-x}Sb_{12}/0.1GaSb$ material

Highly pure metals raw materials Ce, Fe, Co, Sb and Ga were weighted in molar ratio 0.6: 0.4: 3: 1: 12.1: 0.1 in the glove box, respectively. The raw materials were put into a quartz tube, in which the whole wall was coated with carbon film. The quartz tubes were vacuumed and sealed by Ar plasma. The raw materials sealed in quartz tubes were heated with ramp rate 1°C/min and melted at 1050°C, and the duration time was 10 hrs. Subsequently, the quartz tubes were quenched in saturated salt water. And then the condensated bulks (still in quartz tubes under vacuum) were annealed at 650 °C for 96 hrs. The obtained fine powders grounded from bulks were consolidated by spark plasma sintering (SPS) at 550°C for 20 min under a pressure of 50 MPa.

**Claims**

1. A p-type skutterudite material having a general formula:

$$I_yFe_{4-x}M_xSb_{12}/z(\Phi)$$

wherein

I represents one or more filling atoms in a skutterudite phase, with the total filling amount y satisfying $0.01 \leq y \leq 1$; wherein I is selected from the group consisting of Na, K, Ca, Sr, Ba, La, Ce, Pr, Nd, Sm, Eu, Gd and Yb;
M represents one or more dopant atoms, with the doping amount x satisfying $0 \leq x < 3$; wherein M is selected from the group consisting of Co, Ni, Ru, Rh, Os, Ir and Pt;
$\Phi$ represents one or more second phases, with the molar ratio z satisfying $0 < z \leq 0.5$; wherein $\Phi$ is selected from the group consisting of GaAs, GaSb, InAs, InSb, $Zn_3Sb_4$ and solid solutions thereof;
wherein second phase precipitates are dispersed throughout the skutterudite phase.

2. The p-type skutterudite material according to claim 1, wherein $0.05 \leq y \leq 1$.

3. The p-type skutterudite material according to claim 2, wherein $0.1 \leq y \leq 1$.

4. The p-type skutterudite material according to claim 1, further comprising one or more dopant atoms in the skutterudite phase.

5. The p-type skutterudite material according to claim 1, wherein the skutterudite material is single-filled and comprises one or more second phase precipitates dispersed throughout the skutterudite phase.

6. The p-type skutterudite material according to claim 5, further comprising one or more dopant atoms in the skutterudite phase.

7. The p-type skutterudite material according to claim 1, wherein the skutterudite material is multi-filled and comprises one or more second phase precipitates dispersed throughout the skutterudite phase.

8. The p-type skutterudite material according to claim 7, further comprising one or more dopant atoms in the skutterudite phase.

9. The p-type skutterudite material according to claim 1, wherein the second phase comprises nanoscale particles having a size in a range of 2 to 500nm.

10. The p-type skutterudite material according to claim 1, wherein the second phase has a melting point greater than 400°C.

11. The p-type skutterudite material according to claim 1, wherein the second phase is homogeneously dispersed throughout the skutterudite phase.

12. The p-type skutterudite material according to claim 1, wherein the second phase is dispersed along grain boundaries of the skutterudite phase.

13. The p-type skutterudite material according to claim 1, wherein the second phase is dispersed throughout crystal grains of the skutterudite phase.

**Patentansprüche**

1. Ein p-artiger Skutteruditstoff mit einer allgemeinen Formel:

$$I_yFe_{4-x}M_xSb_{12}/z(\Phi)$$

wobei

I für eines oder mehrere Füllatome in einer Skutteruditphase steht, wobei die Gesamtfüllmenge y 0,01≤y≤1 erfüllt; wobei I aus der Gruppe bestehend aus Na, K, Ca, Sr, Ba, La, Ce, Pr, Nd, Sm, Eu, Gd und Yb ausgewählt ist; M für eines oder mehrere Dotieratome steht, wobei die Dotiermenge x 0≤x<3 erfüllt; wobei M aus der Gruppe bestehend aus Co, Ni, Ru, Rh, Os, Ir und Pt ausgewählt ist; Φ für eine oder mehrere zweite Phasen steht, wobei das Molarverhältnis z 0<z≤0,5 erfüllt; wobei Φ aus der Gruppe bestehend aus GaAs, GaSb, InAs, InSb, $Zn_3Sb_4$ und festen Lösungen davon ausgewählt ist; wobei die Ausfällungen der zweiten Phase während der Skutteruditphase verteilt werden.

2. Der p-artige Skutteruditstoff nach Anspruch 1, wobei y 0,05≤y≤1.

3. Der p-artige Skutteruditstoff nach Anspruch 2, wobei y 0,1≤y≤1.

4. Der p-artige Skutteruditstoff nach Anspruch 1, weiterhin umfassend eines oder mehrere Dotieratome in der Skutteruditphase.

5. Der p-artige Skutteruditstoff nach Anspruch 1, wobei der Skutteruditstoff einfach gefüllt ist und eine oder mehrere während der Skutteruditphase verteilte Ausfällungen einer zweiten Phase umfasst.

6. Der p-artige Skutteruditstoff nach Anspruch 5, weiterhin umfassend eines oder mehrere Dotieratome in der Skutteruditphase.

7. Der p-artige Skutteruditstoff nach Anspruch 1, wobei der Skutteruditstoff mehrfach gefüllt ist und eine oder mehrere während der Skutteruditphase verteilte Ausfällungen einer zweiten Phase umfasst.

8. Der p-artige Skutteruditstoff nach Anspruch, weiterhin umfassend eines oder mehrere Dotieratome in der Skutteruditphase.

9. Der p-artige Skutteruditstoff nach Anspruch 1, wobei die zweite Phase nanoskalige Teilchen mit einer Größe im Bereich von 2 bis 500 nm umfasst.

10. Der p-artige Skutteruditstoff nach Anspruch 1, wobei die zweite Phase einen Schmelzpunkt über 400 °C hat.

11. Der p-artige Skutteruditstoff nach Anspruch 1, wobei die zweite Phase während der Skutteruditphase homogen verteilt wird.

12. Der p-artige Skutteruditstoff nach Anspruch 1, wobei die zweite Phase entlang von Korngrenzen der Skutteruditphase verteilt wird.

13. Der p-artige Skutteruditstoff nach Anspruch 1, wobei die zweite Phase durch Kristallkörner der Skutteruditphase verteilt wird.

**Revendications**

1. Matériau de skuttérudite de type p de la formule générale :

$$I_yFe_{4-x}M_xSb_{12}/z(\Phi)$$

où

I représente un ou plusieurs atomes de remplissage dans une phase de skuttérudite, avec la quantité totale de remplissage y satisfaisant à la relation 0,01 ≤ y ≤ 1; où I est sélectionné parmi le groupe consistant en Na, K, Ca, Sr, Ba, La, Ce, Pr, Nd, Sm, Eu, Gd et Yb ;
M représente un ou plusieurs atomes dopants, avec la quantité de dopant x satisfaisant à la relation 0 ≤ x < 3 ; où M sélectionné parmi le groupe consistant en Co, Ni, Ru, Rh, Os, Ir et Pt ;
Φ représente une ou plusieurs secondes phases, avec le rapport molaire z satisfaisant à la relation 0 < z ≤ 0,5 ; où Φ sélectionné parmi le groupe consistant en GaAs, GaSb, InAs, InSb, $Zn_3Sb_4$ et les solutions solides de ceux-ci ;

où les précipités de seconde phase sont dispersés dans toute la phase de skuttérudite.

2. Matériau de skuttérudite de type p selon la revendication 1, où $0,05 \leq y \leq 1$.

3. Matériau de skuttérudite de type p selon la revendication 2, où $0,1 \leq y \leq 1$.

4. Matériau de skuttérudite de type p selon la revendication 1, comprenant en outre un ou plusieurs atomes de dopants dans la phase de skuttérudite.

5. Matériau de skuttérudite de type p selon la revendication 1, où le matériau de skuttérudite est de remplissage simple et comprend un ou plusieurs précipités de seconde phase dispersés dans toute la phase de skuttérudite.

6. Matériau de skuttérudite de type p selon la revendication 5, comprenant en outre un ou plusieurs atomes de dopants dans la phase de skuttérudite.

7. Matériau de skuttérudite de type p selon la revendication 1, où le matériau de skuttérudite est de remplissage multiple et comprend un ou plusieurs précipités de seconde phase dispersés dans toute la phase de skuttérudite.

8. Matériau de skuttérudite de type p selon la revendication 7, comprenant en outre un ou plusieurs atomes de dopants dans la phase de skuttérudite.

9. Matériau de skuttérudite de type p selon la revendication 1, où la seconde phase comprend des particules à l'échelle du nanomètre d'une taille comprise entre 2 et 500 nm.

10. Matériau de skuttérudite de type p selon la revendication 1, où la seconde phase a un point de fusion supérieur à 400°C.

11. Matériau de skuttérudite de type p selon la revendication 1, où la seconde phase est dispersée de façon homogène dans toute la phase de skuttérudite.

12. Matériau de skuttérudite de type p selon la revendication 1, où la seconde phase est dispersée le long des limites de grain de la phase de skuttérudite.

13. Matériau de skuttérudite de type p selon la revendication 1, où la seconde phase est dispersée de façon homogène dans tous les grains de cristal de la phase de skuttérudite.

Fig. 1

Fig. 2

Fig. 3

Fig. 4

Fig. 5

Fig. 6

Fig. 7

Fig. 8

High pure raw materials of
metal elements or compounds

Weighing, sealing
melting, quenching

A solid bulk with every
component distribued
homogenously

annealing

$I_yM_xFe_{4-x}Sb_{12}/z(2^{nd}$ phase)composite powder

sintering

$I_yM_xFe_{4-x}Sb_{12}/z(2^{nd}$ phase)composite thermoelectric

Fig. 9

High pure raw materials of
metal elements or compounds

Weighing, sealing
melting, quenching

A solid bulk with every
component distribued
homogenously

annealing

$I_yM_xFe_{4-x}Sb_{12}/z(2^{nd}$ phase)
multi-filling plus composite powder

sintering

$I_yM_xFe_{4-x}Sb_{12}/z(2^{nd}$ phase)
multi-filling plus composite thermoelectric

Fig. 10

High pure raw materials of
metal elements or compounds

Weighing, sealing
melting, quenching

A solid bulk with every
component distribued
homogenously

annealing

$I_yM_xFe_{4-x}Sb_{12}/z(2^{nd} \text{ phase})$
multi-filling plus composite powder

sintering

$I_yM_xFe_{4-x}Sb_{12}/z(2^{nd} \text{ phase})$
multi-filling plus composite thermoelectric

Fig. 11